# EUROPEAN PATENT SPECIFICATION

(11) **EP 1 411 388 B1**
(45) Date of publication and mention of the grant of the patent: **20.12.2006**
(21) Application number: 03255649.0
(22) Date of filing: 10.09.2003
(51) Int. Cl.: G03F 1/00, G03F 7/20, B08B 7/00

(54) **A method of cleaning by removing particles from surfaces, a cleaning apparatus and a lithographic projection apparatus**
Verfahren zur Reinigung durch Entfernung von Teilchen von Oberflächen, Reinigungsvorrichtung und lithographischer Projektionsapparat
Procédé pour nettoyer par enlèvement de particules présentes sur des surfaces, appareil de nettoyage et appareil de projection lithographique

(30) Priority: 12.09.2002 EP 02256312
(43) Date of publication of application: 21.04.2004
(73) Proprietor: ASML Netherlands B.V., 5504 DR Veldhoven (NL)
(72) Inventor: Heerens, Gert-Jan, 2871 ZH Schoonhoven (NL)
(74) Representative: Leeming, John Gerard

(56) References cited:
- WO-A-02/07926
- WO-A-02/053300
- US-A- 6 153 044
- US-A1- 2001 055 104
- US-A1- 2002 090 575
- US-A1- 2002 096 647
- US-A1- 2002 118 348
- US-B1- 6 395 102
- DATABASE WPI Section Ch, Week 197411 Derwent Publications Ltd., London, GB; Class M22, AN 1974-20651V XP002228375 & SU 383 531 A (MARTYANOV N E ET AL) 15 August 1973 (1973-08-15)

## Description

The present invention relates to a method of cleaning by removing particles from sensitive surfaces. It is used particularly in conjunction with a lithographic projection apparatus comprising:
- a radiation system for supplying a projection beam of radiation;
- a support structure for supporting patterning means, the patterning means serving to pattern the projection beam according to a desired pattern;
- a substrate table for holding a substrate; and
- a projection system for projecting the patterned beam onto a target portion of the substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, . In the case of a programmable mirror array, the said support structure may be embodied as a frame or table, for example, which may be fixed or movable as required.
- A programmable LCD array. An example of such a construction is given in United States Patent US 5,229,872. As above, the support structure in this case may be embodied as a frame or table, for example, which may be fixed or movable as required.
For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e*.*g*. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus -commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

To ensure a sharp and clean image is projected onto the substrate the mask is thoroughly cleaned before use. Any particles remaining on the surface of the mask could ruin the image and scratch the mask. As the critical dimensions of integrated circuits decrease, the scope for imaging error increases, and so the importance of eliminating stray particles is ever increasing. To avoid scratching particularly delicate masks, a non-contact method of cleaning is desirable. Present methods of non-contact cleaning include laser cleaning, burst cleaning or wet ultrasound cleaning. However, with these methods there is a risk of damage to the mask due to the nature of vibrations induced in the particles.

DATABASE WPI Section Ch, Week 197411 Derwent Publications Ltd., London, GB; Class M22, AN 1974-20651V XP002228375 & SU 383 531 A (MARTYANOV N E ET AL) 15 August 1973 (1973-08-15) discloses a cleaning system in which a chamber is filled with saturated steam and the pressure in the chamber reduced.

It is an object of the present invention to provide a new and improved method of cleaning a mask or other object by removing particles from the surface of the mask or other object.

This and other objects are achieved according to the invention in a method of cleaning a surface of an object by removing particles from the surface of the object comprising the steps of:
- providing a chamber which can be sealed in an air tight manner;
- placing the object in said chamber with the surface to be cleaned exposed;
- sealing said chamber; and
- reducing the gas pressure in said chamber to below 10⁻² mbar,
characterized in that the gas pressure is reduced from atmospheric pressure to 10⁻² mbar in less than 5 seconds

The inventors have found that reducing the gas pressure from atmospheric pressure to 10⁻² mbar achieves beneficial results. Further, the gas pressure drop should preferably take place over less than 5 seconds. To create a greater gas pressure differential the gas pressure can be increased prior to the quick pressure drop.

After quickly reducing the gas pressure, it can then be quickly (i.e. the pressure change takes place in less than 5 seconds) increased, preferably to the original gas pressure before the gas pressure was reduced. For particularly thorough cleaning the gas pressure is repeatedly cycled between a low pressure and a higher pressure.

This cleaning method can be used in conjunction with other methods of removing particles. For example, an electric field can be used to attract and remove particles away from the surface. This would provide an additional force removing the particles. To increase this force further the surface of the object to be cleaned is charged. Alternatively, or additionally, the object is vibrated, which helps to loosen any particles that may be caught on the surface of the object by static friction. Similarly, bombarding the surface of the object to be cleaned with particles helps remove immobile contaminant particles caught by static friction. Due to its inert nature and low price condensed CO₂ has been found to be ideal for this purpose. Changing the temperature of the object can also help dislodged a particle, due to the consequential expansion or contraction of the material. These additional methods of removing particles can either take place during or prior to the chamber depressurization.

To decrease adhesion forces between the particle and the surface of the object to be cleaned a layer of liquid, preferably a solvent can be applied to the surface of the object to be cleaned.

This invention has been developed particularly for the cleaning of lithographic masks, although it is applicable to all other sensitive surfaces.

According to a further aspect of the invention there is provided an apparatus for removing particles from surfaces of objects comprising:
a chamber with a door capable of being sealed in an air tight manner; and at least one of the following:
   means for providing an electric field to attract and remove the particles from the surface;
   means for vibrating the object to be cleaned;
   means for bombarding the surface of the object to be cleaned with particles; and
   means for applying a layer of liquid (52) of the surface of the object to be cleaned
characterized by
means for reducing the gas pressure of the sealed chamber from atmospheric pressure to 10⁻² mbar in less than 5 seconds.

According to a further aspect of the invention there is provided a lithographic apparatus as specified in the opening paragraph, characterized in that it further comprises a device for removing particles from surfaces of objects comprising:
a chamber with a door capable of being sealed in an air tight manner;
means for reducing the gas pressure of the sealed chamber from atmospheric pressure to 10⁻² mbar in less than 5 seconds.

The present invention is therefore particularly applicable to lithography involving EUV radiation as this is an area of lithography which is particularly sensitive to errors.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g*. with a wavelength of 365, 248, 193, 157 or 126 nm) and EUV (extreme ultra-violet radiation, *e.g.* having a wavelength in the range 5-20 nm), as well as particle beams, such as ion beams or electron beams.

Embodiments of the invention will now be described, by way of example only, with reference to the accompanying schematic drawings in which:
Figure 1 depicts a cleaning apparatus according to a first embodiment of the invention;
Figure 2 shows the method of dislodging a particle;
Figure 3 depicts a cleaning apparatus with electrostatic attracting means according to a second embodiment of the invention;
Figure 4 depicts a cleaning apparatus with a vibrating object table according to a third embodiment of the invention;
Figure 5 depicts a cleaning apparatus in which the mask is bombarded by condensed CO₂ according to a fourth embodiment of the invention;
Figure 6 shows a cross-section of a mask with a layer of solvent; and
Figure 7 depicts a lithographic projection apparatus according to an embodiment of the invention.

In the Figures, corresponding reference symbols indicate corresponding parts.

### Embodiment 1

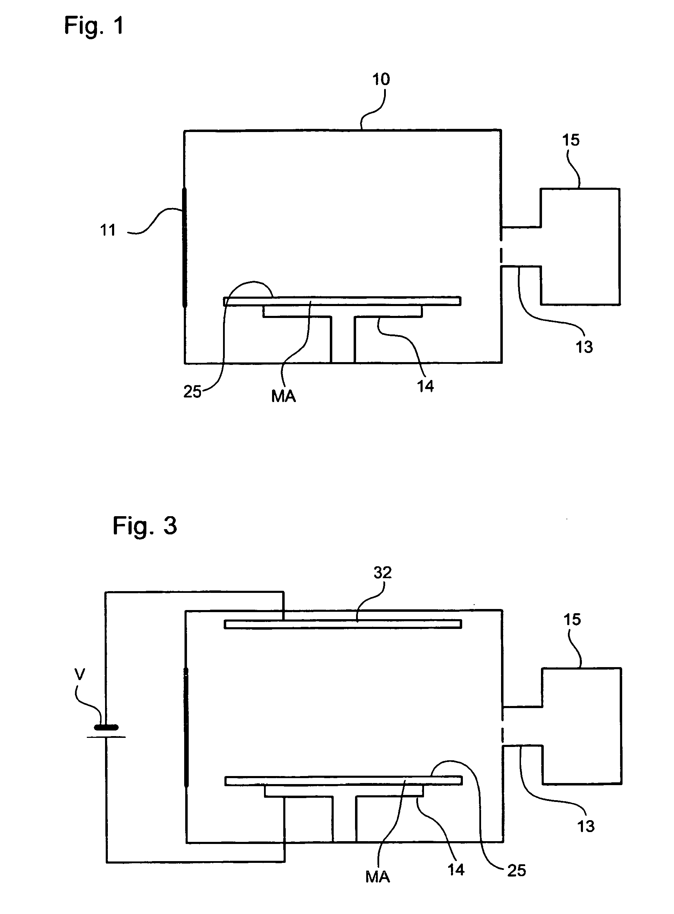

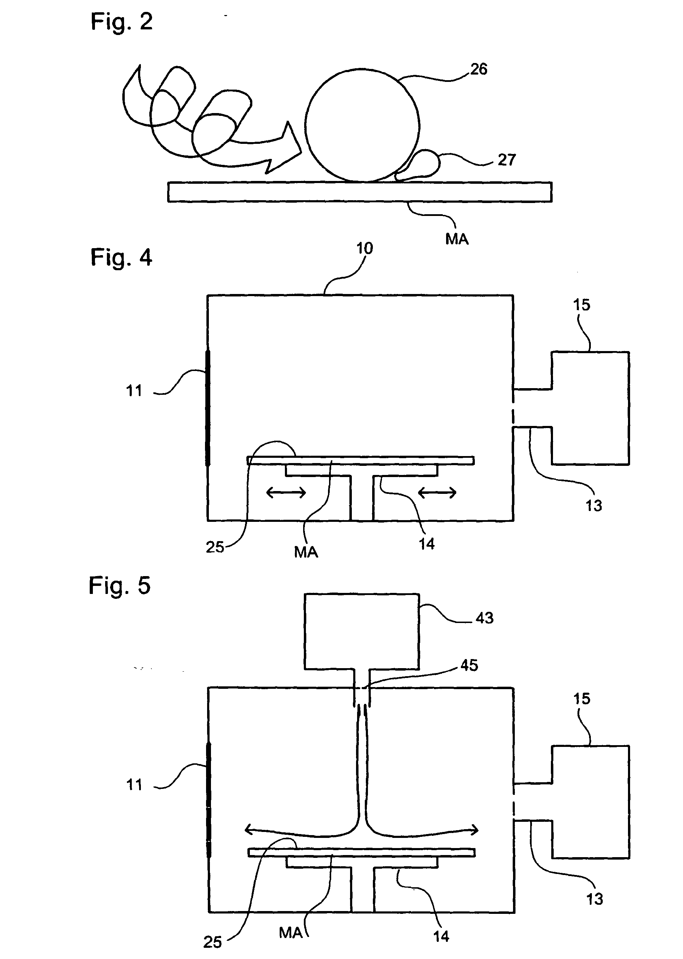

Figure 1 shows an apparatus according to the invention with a chamber 10 having a door 11 which can be sealed in an air tight fashion, such that there can be a large pressure differential between inside and outside the chamber 10. A pipe 13 leads from the inside of the chamber 10 to pumping means 15 and inside the chamber there is an object table 14. A mask MA to be cleaned is fixed on the object table 14 with the surface to be cleaned 25 exposed. The mask MA should be firmly fixed to the object table 14 by, for example vacuum suction means. Once the door 11 has been sealed the pumping means reduce the gas pressure inside the chamber 10 from atmospheric pressure to 10⁻² mbar in about 1 second. The time to reduce the gas pressure can vary, but should not be more than 5 seconds. The inventors have conducted experiments to show that this rapid depressurization can successfully dislodge particles. It is not known exactly how the depressurization dislodges the particles but a probable method is that as the gas is extracted from the chamber 10 very quickly, pockets of gas 27 caught behind the particles 26 dislodge the particles as shown in Figure 2. Another possible force dislodging the particles 26 is the turbulent flow of the gas which can knock the particles 26, therefore dislodging them. Once the particles 26 have been dislodged they are extracted from the chamber 10 with the air and then removed from the air stream. After decreasing the gas pressure the gas pressure is then increased back up to atmospheric pressure in 1 second. Rapidly increasing the gas pressure inside the chamber also generates turbulence and can pockets of air can similarly dislodge the particles. The cycle of decreasing the pressure from atmospheric pressure to a lower pressure and back up to atmospheric pressure can be repeated as many times as necessary.

The pressure does not have to be decreased to 10⁻² mbar, but the greater and faster the pressure drop the more effective the cleaning method. Thus, decreasing the pressure to 10⁻⁷mbar would be more advantageous still. Similarly, the gas pressure does not have to be rapidly decreased from 1 atmosphere. For example the gas pressure in the chamber could be increased to 10, or even 100 atmospheres (or any pressure in between) to generate a greater rapid pressure drop to 10⁻² or 10⁻⁷ mbar (or any pressure in between).

To reduce the adhesive forces between the particles 26 and the surface of the mask 25 to be cleaned the components of gas in the chamber 10 can be varied. Optimizing the gas mixture can also be used to improve, and increase the chances of, particle removal due to e.g. different viscosities.

### Embodiment 2

The second embodiment is the same as the first embodiment except for the features described in the following description.

As shown in Figure 3, there is a chargable plate 32 in the chamber opposite the surface of the mask to be cleaned 25. In this embodiment the object table 14 is made of metal and can also be charged. At the same time as the rapid decrease in pressure of the chamber 10 a voltage source V charges the charged plate 32 and the object table 14 to between 10 and 2000 V. The mask MA on the object table 14 will therefore also become charged. As the mask MA is charged, the particles on it will be attracted towards the charged plate 32. There is therefore another force for dislodging the particles 26.

### Embodiment 3

The third embodiment is the same as the first embodiment except for the features described in the following description. In this embodiment the object table 14 vibrates during depressurization of the chamber 10, as shown in Figure 4. The vibrations shown in Figure 4 (by means of double-headed arrows) are linearly parallel to the plane of the mask MA and are of the order of 1mm. The frequency of vibration can be between 50 to 500Hz. One of the forces adhering the particles 26 to the mask MA is static friction. When the object table 14 (and also the mask MA since it is firmly fixed to the object table 14) changes direction during the vibration the inertia of the particles means that they continue to travel in the original direction while the mask MA changes direction beneath them. This overcomes the static friction and therefore dislodges the particles 26.

Instead of linear vibrations rotational vibrations parallel to the plane of the mask MA could also be used. These should be approximately 5° at a frequency of between 1 and 5000 Hz. Alternatively linear vibrations perpendicular to the plane of the mask MA could be used.

### Embodiment 4

The fourth embodiment is the same as the first embodiment except for the features described in the following description. In this embodiment, shown in Figure 5, condensed CO₂ is contained in a container 43 outside the chamber 10. The condensed CO₂ is projected through a one way valve 45 towards the mask MA at the same time as the chamber 10 is depressurized. When the particles of condensed CO₂ bombard the mask MA the force dislodges the particles 26 from the surface of the mask 25 to be cleaned. The condensed CO₂ evaporates and is extracted from the chamber 10 during the depressurization. This method is not restricted to the used of condensed CO₂, and any inert liquid or solid in particle form could be used.

### Embodiment 5

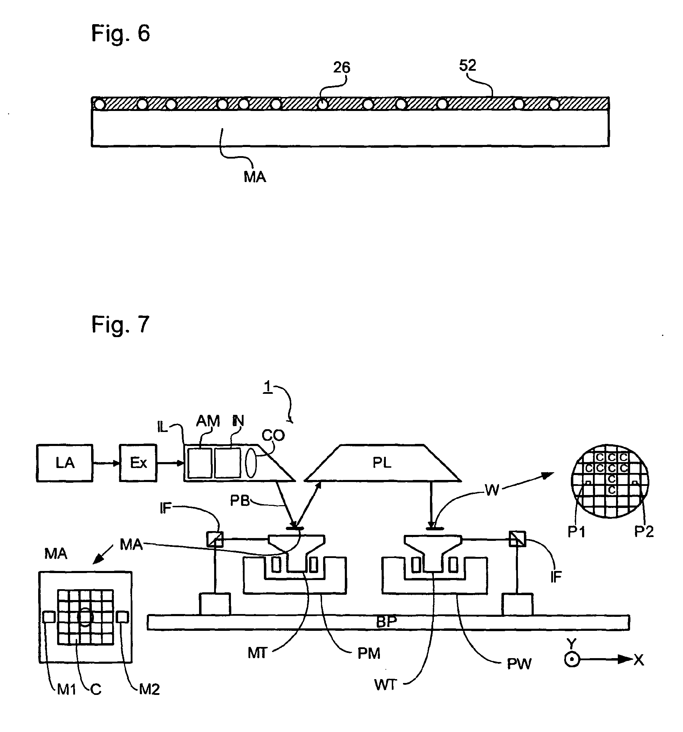

The fifth embodiment is the same as the first embodiment except for the features described in the following description. A thin layer of solvent 52 is applied to the surface of the mask 25 to be cleaned prior to the depressurization of the chamber 10 as shown in Figure 6. The solvent reduces the adhesion forces between the particles 26 and the mask MA, and dissolves the particles 26. The layer of solvent 52 should therefore be uniform across the entire surface of the substrate to be cleaned to ensure that the solvent is adjacent to all the particles 26 and preferably sufficiently thick to completely cover the particles 26 in order to dissolve or suspend the particles 26. As the gas pressure in the chamber is reduced and gas is extracted, the solvent, together with the dissolved or suspended particles will be extracted from the chamber 10. The particles can then be removed from the gas. The solvent can be varied to optimize the particles 26 solubility therein.

### Embodiment 6

The apparatus described above can be used as an individual cleaning device, or it can be part of a larger lithographic apparatus. Figure 7 schematically depicts a lithographic projection apparatus in which a device described in any one of the previous embodiments could be incorporated. The apparatus comprises:
a radiation system Ex, IL, for supplying a projection beam PB of radiation (*e.g.* EUV radiation), which in this particular case also comprises a radiation source LA;
a first object table (mask table) MT provided with a mask holder for holding a mask MA (*e.g*. a reticle), and connected to first positioning means for accurately positioning the mask with respect to item PL;
a second object table (substrate table) WT provided with a substrate holder for holding a substrate W (*e.g.*. a resist-coated silicon wafer), and connected to second positioning means for accurately positioning the substrate with respect to item PL;
a projection system ("lens") PL (*e.g*. a refractive) for imaging an irradiated portion of the mask MA onto a target portion C (*e.g.* comprising one or more dies) of the substrate W.
As here depicted, the apparatus is of a reflective type (*e.g.* has a reflective mask). However, in general, it may also be of a transmissive type, for example (*e.g*. with a transmissive mask). Alternatively, the apparatus may employ another kind of patterning means, such as a programmable mirror array of a type as referred to above.

The source LA (*e.g* a laser-produced or discharge plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go *(i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the y direction) with a speed *v*, so that the projection beam PB is caused to scan over a mask image; concurrently, the substrate table WT is simultaneously moved in the same or opposite direction at a speed *V = Mv*, in which *M* is the magnification of the lens PL (typically, *M* = 1/4 or 1/5). In this manner, a relatively large target portion C can be exposed, without having to compromise on resolution.

Whilst specific embodiments of the invention have been described above, it will be appreciated that the invention may be practiced otherwise than as described. The description is not intended to limit the invention.

## Claims

1. A method of cleaning a surface of an object by removing particles from the surface of the object comprising the steps of:
- providing a chamber (10) which can be sealed in an air tight manner;
- placing the object in said chamber (10) with the surface to be cleaned exposed;
- sealing said chamber; and
- reducing the gas pressure in said chamber to below 10⁻² mbar,
**characterized in that** the gas pressure is reduced from atmospheric pressure to 10⁻² mbar in less than 5 seconds.

2. A method according to any one of the preceding claims wherein said object is a lithographic mask (MA).

3. A method according to any one of the preceding claims further comprising the subsequent step of quickly increasing the gas pressure.

4. A method according to claim 3 wherein the gas pressure is quickly increased to the original gas pressure before the air pressure was reduced.

5. A method according to either claim 3 or claim 4 wherein the gas pressure is repeatedly cycled between a low pressure and a higher pressure.

6. A method according to any one of the preceding claims wherein the gas pressure is increased prior to reducing the gas pressure quickly.

7. A method according to any one of the preceding claims further comprising the step of providing an electric field to attract and remove the particles from said surface to be cleaned.

8. A method according to claim 7 wherein the surface of the object to be cleaned is charged to aid particle removal.

9. A method according to any one of the preceding claims wherein said object is vibrated.

10. A method according to any one of the preceding claims wherein the temperature of said object is changed.

11. A method according to any one of the preceding claims wherein particles bombard the surface of the object to be cleaned.

12. A method according to claim 11 wherein the bombarding particles are condensed CO₂.

13. A method according to any one of the preceding claims further comprising the step of applying a layer of liquid (52) to the surface of the object to be cleaned.

14. A method according to claim 13 wherein said layer is uniform across the entire surface of the object to be cleaned.

15. An apparatus for removing particles from surfaces of objects comprising:
a chamber (10) with a door (11) capable of being sealed in an air tight manner; and at least one of the following:
means for providing an electric field to attract and remove the particles from the surface;
means for vibrating the object to be cleaned;
means for bombarding the surface of the object to be cleaned with particles; and
means for applying a layer of liquid (52) of the surface of the object to be cleaned
**characterized by**
means for reducing the gas pressure of the sealed chamber from atmospheric pressure to 10⁻² mbar in less than 5 seconds;

16. A lithographic projection apparatus comprising:
- a radiation system for providing a projection beam of radiation;
- a support structure for supporting patterning means (MA), the patterning means serving to pattern the projection beam (PB) according to a desired pattern;
- a substrate table (WT) for holding a substrate (W);
- a projection system (PL) for projecting the patterned beam (PB) onto a target portion of the substrate (W),
**characterized in that** it further comprises a device for removing particles from surfaces of objects comprising:
a chamber (10) with a door (11) capable of being sealed in an air tight manner;
means for reducing the gas pressure (15) of the sealed chamber from atmospheric pressure to 10⁻² mbar in less than 5 seconds.

## Patentansprüche

1. Verfahren zur Reinigung einer Oberfläche eines Objektes durch Entfernen von Teilchen von der Oberfläche des Objektes mit den nachfolgenden Schritten :
- Bereitstellen einer Kammer (10), die luftdicht abgeschlossen werden kann ;
- Platzierung des Objektes in der Kammer (10) mit freier, zu reinigender Oberfläche ;
- Versiegelung der Kammer; und
- Reduzierung des Gasdrucks in der Kammer auf unter 10⁻² mbar, **dadurch gekennzeichnet, dass** der Gasdruck in weniger als 5 Sekunden von Atmosphärendruck auf 10⁻² mbar reduziert wird.

2. Verfahren nach einem der vorhergehenden Ansprüche, wobei es sich bei dem Objekt um eine lithographische Maske (MA) handelt.

3. Verfahren nach einem der vorhergehenden Ansprüche, das weiterhin den folgenden Schritt umfasst, dass der Gasdruck rasch erhöht wird.

4. Verfahren nach Anspruch 3, wobei der Gasdruck rasch auf den ursprünglichen Gasdruck erhöht wird, bevor der Luftdruck reduziert wurde.

5. Verfahren nach Anspruch 3 oder 4, wobei der Gasdruck zwischen einem niedrigen Druck und einem höheren Druck zyklisch wiederholt wird.

6. Verfahren nach einem der vorhergehenden Ansprüche, wobei der Gasdruck vor der raschen Reduzierung des Gasdrucks erhöht wird.

7. Verfahren nach einem der vorhergehenden Ansprüche, das weiterhin den Schritt umfasst, dass ein elektrisches Feld geliefert wird, um die Teilchen auf der zu reinigenden Oberfläche anzuziehen und von ihr zu entfernen.

8. Verfahren nach Anspruch 7, wobei die Oberfläche des zu reinigenden Objektes aufgeladen wird, um die Entfernung der Teilchen zu unterstützen.

9. Verfahren nach einem der vorhergehenden Ansprüche, wobei das Objekt gerüttelt wird.

10. Verfahren nach einem der vorhergehenden Ansprüche, wobei die Temperatur des Objektes geändert wird.

11. Verfahren nach einem der vorhergehenden Ansprüche, wobei die Teilchen die Oberfläche des zu reinigenden Objektes beschießen.

12. Verfahren nach Anspruch 11, wobei es sich bei den Teilchen, mit denen die Oberfläche beschossen wird, um kondensiertes CO₂ handelt.

13. Verfahren nach einem der vorhergehenden Ansprüche, das weiterhin den Schritt umfasst, dass eine Flüssigkeitsschicht (52) auf die Oberfläche des zu reinigenden Objektes aufgetragen wird.

14. Verfahren nach Anspruch 13, wobei die Schicht gleichmäßig über die gesamte Oberfläche des zu reinigenden Objektes verläuft.

15. Vorrichtung zum Entfernen von Teilchen von Oberflächen von Objekten mit :
einer Kammer (10) mit einer Tür (11), die luftdicht versiegelt werden kann ; und
mindestens einer der folgenden Vorrichtungen :
eine Vorrichtung zum Bereitstellen eines elektrischen Feldes zum Anziehen und Entfernen der Teilchen von der Oberfläche ;
eine Vorrichtung zum Rütteln des zu reinigenden Objektes ;
eine Vorrichtung zum Beschießen der Oberfläche des zu reinigenden Objektes mit Teilchen ;
und
eine Vorrichtung zum Auftragen einer Flüssigkeitsschicht (529 auf die Oberfläche des zu reinigenden Objektes,
**gekennzeichnet durch**
eine Vorrichtung zur Reduzierung des Gasdrucks der versiegelten Kammer vom Atmosphärendruck auf 10⁻² mbar in weniger als 5 Sekunden ;

16. Lithographischer Projektionsapparat mit :
- einem Bestrahlungssystem zur Lieferung eines Projektionsstrahls der Strahlung ;
- einer Tragkonstruktion zum Halten der Bemusterungsvorrichtung (MA), wobei die Bemusterungsvorrichtung dazu dient, den Projektionsstrahl (PB) entsprechend einem gewünschten Muster zu bemustern ;
- einem Substrattisch (WT) zum Halten eines Substrats (W) ;
- einem Projektionssystem (PL), um den bemusterten Strahl (PB) auf einen Zielabschnitt des Substrats (W) zu projizieren,
**dadurch gekennzeichnet, dass** er außerdem eine Vorrichtung zum Entfernen von Teilchen von Oberflächen von Objekten umfasst, mit :
einer Kammer (10) mit einer Tür (11), die luftdicht versiegelt werden kann ;
einer Vorrichtung zur Reduzierung des Gasdrucks (15) der versiegelten Kammer von Atmosphärendruck auf 10⁻² mbar in weniger als 5 Sekunden.

## Revendications

1. Procédé pour nettoyer une surface d'un objet en éliminant des particules de la surface de l'objet, comprenant les étapes consistant à :
- fournir une chambre (10) qui peut être rendue étanche d'une manière imperméable à l'air ;
- placer l'objet dans ladite chambre (10) avec la surface à nettoyer exposée ;
- rendre étanche ladite chambre ; et
- réduire la pression gazeuse dans ladite chambre à moins de 10⁻² mbar,
**caractérisé en ce que** la pression gazeuse est réduite de la pression atmosphérique à 10⁻² mbar en moins de 5 secondes.

2. Procédé selon l'une quelconque des revendications précédentes, dans lequel ledit objet est un masque lithographique (MA).

3. Procédé selon l'une quelconque des revendications précédentes, comprenant de plus l'étape ultérieure d'augmentation rapide de la pression gazeuse.

4. Procédé selon la revendication 3, dans lequel la pression gazeuse est rapidement augmentée jusqu'à la pression gazeuse d'origine avant que la pression d'air n'ait été réduite.

5. Procédé selon la revendication 3 ou 4, dans lequel la pression gazeuse suit un cycle de manière répétée entre une basse pression et une pression supérieure.

6. Procédé selon l'une quelconque des revendications précédentes, dans lequel la pression gazeuse est augmentée avant de réduire la pression gazeuse rapidement.

7. Procédé selon l'une quelconque des revendications précédentes, comportant de plus l'étape de fourniture d'un champ électrique pour attirer et éliminer les particules de ladite surface à nettoyer.

8. Procédé selon la revendication 7, dans lequel la surface de l'objet à nettoyer est chargée pour faciliter l'élimination de particules.

9. Procédé selon l'une quelconque des revendications précédentes, dans lequel ledit objet est amené à vibrer.

10. Procédé selon l'une quelconque des revendications précédentes, dans lequel la température dudit objet est changée.

11. Procédé selon l'une quelconque des revendications précédentes, dans lequel des particules bombardent la surface de l'objet à nettoyer.

12. Procédé selon la revendication 11, dans lequel les particules bombardées sont du CO₂ condensé.

13. Procédé selon l'une quelconque des revendications précédentes, comportant de plus l'étape d'application d'une couche de liquide (52) à la surface de l'objet à nettoyer.

14. Procédé selon la revendication 13, dans lequel ladite couche est uniforme à travers la surface entière de l'objet à nettoyer.

15. Appareil pour éliminer des particules de surfaces d'objets, comprenant :
une chambre (10) munie d'une porte (11) capable d'être rendue étanche d'une manière imperméable à l'air ; et
au moins l'un parmi les moyens suivants :
des moyens pour établir un champ électrique afin d'attirer et éliminer les particules de la surface ;
des moyens pour faire vibrer l'objet à nettoyer ;
des moyens pour bombarder la surface de l'objet à nettoyer par des particules ; et
des moyens pour appliquer une couche de liquide (52) sur la surface de l'objet à nettoyer
**caractérisé par**
des moyens pour réduire la pression gazeuse de la chambre rendue étanche de la pression atmosphérique à 10⁻² mbar en moins de 5 secondes.

16. Appareil de projection lithographique, comportant :
- un système de rayonnement pour délivrer un faisceau de projection de rayonnement ;
- une structure de support pour supporter des moyens de mise en forme (MA), les moyens de mise en forme servant à mettre en forme le faisceau de projection (PB) conformément à un motif voulu ;
- une table de substrat (WT) pour supporter un substrat (W) ;
- un système de projection (PL) pour projeter le faisceau mis en forme (PB) sur une partie cible du substrat (W),
**caractérisé en ce qu'**il comporte de plus un dispositif pour éliminer des particules de surfaces d'objets comprenant :
une chambre (10) munie d'une porte (11) capable d'être rendue étanche d'une manière imperméable à l'air ;
des moyens pour réduire la pression gazeuse (15) de la chambre rendue étanche de la pression atmosphérique à 10⁻² mbar en moins de 5 secondes.
